# EUROPEAN PATENT SPECIFICATION

(11) **EP 2 840 600 B1**
(45) Date of publication and mention of the grant of the patent: **12.04.2023**
(21) Application number: 13181317.2
(22) Date of filing: 22.08.2013
(51) Int. Cl.: H01L 21/677

(54) **Process station for a machine as well as control device and control method for controlling a movement in a process of a machine**
Prozessstation für eine Maschine sowie ein Controller und eine Kontrollmethode zur Bewegungssteuerung in einem Prozess der Maschine
Station de traitement pour une machine et contrôleur et méthode de contrôle pour contrôler un mouvement dans un procédé de la machine

(43) Date of publication of application: 25.02.2015
(73) Proprietor: Robert Bosch GmbH, 70442 Stuttgart (DE)
(72) Inventor: Hibbs, Richard, 5731JV Mierlo (NL); Haring, Menno, 5615RE Eindhoven (NL)

(56) References cited:
- EP-A2- 2 111 091
- WO-A1-2006/135464
- WO-A2-98/49646
- US-A1- 2007 013 642

## Description

The present invention relates to a machine as well as a control device and a control method for controlling a movement in a process of a machine, in which it is in particular possible to eliminate a need for a movement of a pick-and-place robot in a conveying direction of the conveying system.

In machines for producing an article, conveying systems are used to convey parts, tools, etc., which are usable for the production of the article, to different stations of the machine. Such a machine is described, for example, in US 4,096,821 which discloses a system for fabricating thin-film electronic components upon a substrate.

US 2007/013642 A1 shows, as another example in this regard, a system for transferring flat panel displays between processing stations of a display manufacturing line.

In such machines, usually the conveying systems comprise a conveying belt to convey substrates one after another with the same velocity to a process station. In the process station, the substrates are taken from the belt, processed by robots moving in the X-, Y-, Z- and Θ-directions, and then put back on the belt. Thus, the substrates stand still in the process station so that the robots can pick and place items on the substrates. Thereafter, all of the substrates are conveyed with the conveying belt with the same velocity to the next process station. EP 2 111 091 A2 shows another example of such a machine.

Such a handling of the substrates needs a lot of handling steps and is thus time-consuming. Consequently, the process costs increase. Furthermore, since robots capable to move in the X-, Y-, Z- and Θ- directions are expensive, high costs for the machine itself result. This contributes to an increase in the process costs of the machine, too.

WO 98/49646 A2 shows a dynamically reconfigurable assembly line for electronic products, in which PCBs are conveyed between workcells and pick-and-placement machines are used in the workcells. As in the abovereferenced state of the art, the conveying system does not contribute to the movement of the PCB in the workcell as a process station during performing a process in the process station.

The prior art does at least not show a conveying system which is arranged to convey carriers in a specific conveying direction for conveying a load to and/or away from at least one process station and to convey the carriers in the same specific conveying direction for conveying the load in the at least one process station, wherein a control is performed in which at least one of the carriers has an individual velocity, such that the carrier can be moved back and forth in the specific conveying direction only and such that in case the carrier is in reach of a robot of a process station, the movement of the carrier is coupled, in particular synchronized, with the movement of the robot which is movable to handle the load in a moving direction different from the specific conveying direction.

Therefore, it is an object of the present invention to provide a machine as well as a control device and a control method for controlling a movement in a process of a machine, which process station, device and method each solve the above-mentioned problems. In particular, a machine as well as a control device and a control method for controlling a movement in a process of a machine shall be provided with which the process time of the machine can be reduced and thus the operation costs of the machine and possibly also the acquisition costs of the machine can be reduced.

This object is solved by a machine according to claim 1.

Due to the control performed in the above-mentioned process station, the time for performing a process in a process station of the machine and thus the machine itself is shortened compared to a conventional control of the machine. As a result, the process costs are diminished.

The process station is in particular advantageous in cases where the process time itself cannot be reduced. Since the control performed in the process station can reduce the handling time in the process station of a machine, the entire time needed in the process station can be reduced.

Moreover, it is possible with the process station to use a simple cheaper robot since at least one moving direction in handling the article as the load is taken over by the conveying system. As a result, the machine costs and thus the process costs of the machine themselves are diminished.

With the above-described process station, the carriers of the conveying system can move in the conveying system with the same or (a) different velocity/velocities. Consequently, the machine is more flexible in adapting to processes to be performed by the machine.

Further, since the robot does not move in the specific conveying direction, the process station requires less space in the specific conveying direction. As a result, the machine could be built more compact which contributes to lowering the costs for the machine, as well.

In addition, the movement of the conveying system in the specific conveying direction can be performed with very high accuracy. In particular, a positioning accuracy in the range of up to approximately 0.1 mm and even up to approximately 1 µm can be achieved. Due to this it is possible to replace a movement of the robot in the specific conveying direction by the movement of the conveying system in the specific conveying direction in processes requiring such a high positioning accuracy.

Further advantageous developments of the machine are set out in the dependent claims.

In a specific implementation form, the control for conveying the load in the specific conveying direction and the control for moving the robot in the moving direction are synchronized in handling the load.

The process station could comprise more than one robot.

It is also possible that the process station is used in a process requiring a positioning accuracy of up to approximately 1 µm for handling the load.

The process station might be a process station for producing a semiconductor element.

The above-described process station is part of a machine which could further comprise other process stations and comprises a conveying system for conveying at least one carrier by magnetic force in a specific conveying direction, the carrier being used for conveying a load to be handled in the machine, wherein the conveying system is arranged to convey the load to and/or away from the at least one process station.

The machine further comprises a first control unit for controlling the carrier to move by magnetic force in the specific conveying direction, and a second control unit for controlling the robot to move in the moving direction different from the specific conveying direction of the conveying system to handle the load.

The conveying system can be configured to convey a substrate as the load and the robot/s is/are configured to add items to the substrate.

The above-mentioned object is further solved by a control device for controlling a movement in a process of a machine according to claim 8.

The control device achieves the same advantages as mentioned above for the process station. Further advantageous developments of the control device are set out in the dependent claims.

The control for conveying the load in the specific conveying direction and the control for moving the robot in the moving direction could be synchronized in handling the load.

According to the invention, the first control unit is configured to control the carrier such that the load is moved in the specific conveying direction such that the robot does not have to move in the specific conveying direction.

The specific conveying direction might be the X-direction, the moving direction of the robot might be at least one direction of the Y-direction and/or the Z-direction and/or the Θ-direction, and the X-direction, the Y-direction and the Z-direction might be different from each other and arranged vertically to each other. This is in particular advantageous, when the carriers can move independently in the X-direction during pick and place in which the robot moves in the Y- and/or Z- and/or Θ-directions.

The above-mentioned object is further solved by a control method for controlling a movement in a process of a machine according to claim 13.

The control method achieves the same advantages as mentioned above for the control device. Further advantageous developments of the control method are set out in the dependent claims.

The control for conveying the load in the specific conveying direction and the control for moving the robot in the moving direction might be synchronized in handling the load.

The specific conveying direction could be the X-direction, the moving direction of the robot could be at least one direction of the Y-direction and/or the Z-direction and/or the Θ-direction, and the X-direction, the Y-direction and the Z-direction could be different from each other and arranged vertically to each other.

Further possible implementations of the invention also comprise combinations of specific features described above or in the following as regards the embodiments, while the scope of the invention is defined by the claims.

In the following, the present invention is described in more detail on the basis of an embodiment by reference to the appended drawings. The figures thereof show:
Fig. 1 a schematic top view of a machine comprising a conveying system with a control device according to an embodiment;
Fig. 2 a schematic side view of the machine of Fig. 1; and
Fig. 3 a flow chart schematically illustrating a control method according to the first embodiment.

In the figures, similar elements or elements having similar function are marked with the same reference signs unless specified otherwise.

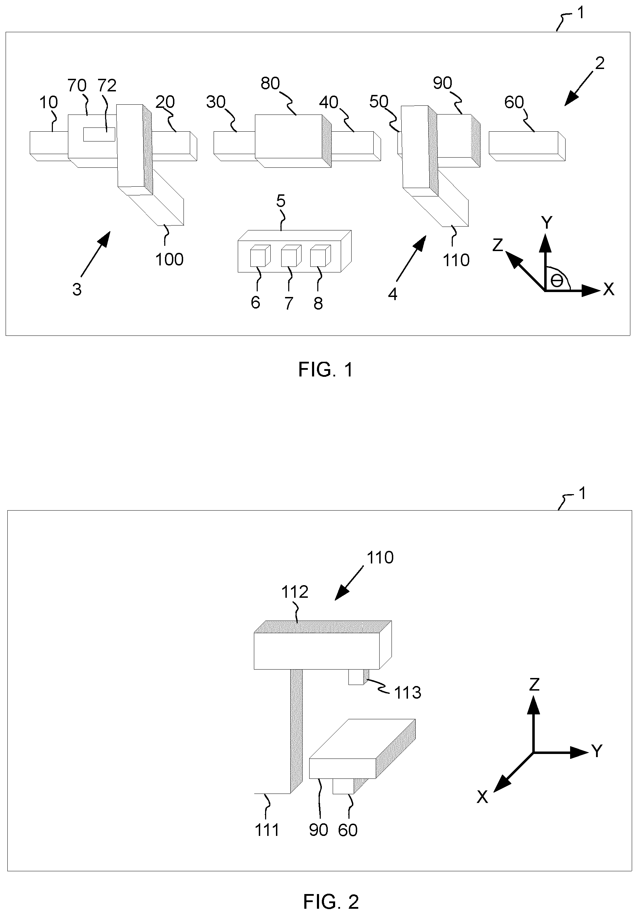

Fig. 1 shows a machine 1 for producing an article, for example a semiconductor element on a substrate like a wafer, etc. The machine 1 comprises a conveying system 2 connecting a first process station 3 and a second process station 4. The machine 1 further comprises a control device 5 having a first control unit 6, a second control unit 7, and a third control unit 8. The machine 1 could be a production line.

The conveying system 2 in Fig. 1 comprises a first driving device 10, a second driving device 20, a third driving device 30, a fourth driving device 40, a fifth driving device 50, a sixth driving device 60, a first carrier 70, carrying a load 72, like an article to be produced by the machine 1, etc., a second carrier 80, and a third carrier 90. The first to third carriers 70, 80, 90 are movable in the conveying system 2 by magnetic force created by the first to sixth driving devices 10, 20, 30, 40, 50, 60 and controlled by the control device 5. The first to sixth driving devices 10, 20, 30, 40, 50, 60 build up a track of the conveying system 2. The carriers 70, 80, 90 are movable over the track of the conveying system 2 from a first position to a second position different from the first position. For example, the first position is the position on the left side of the conveying system 2 in Fig. 1, where the first driving device 10 is arranged in Fig. 1. The second position could then be the position of the sixth driving device 60, i.e. a position on the right side in Fig. 1.

In Fig. 1, a first robot 100 is arranged in the first process station 3 at the conveying system 2 such that the first robot 100 can pick and place items necessary in producing the article onto one of the first to third carriers 70, 80, 90 and/or the load 72. In addition, a second robot 110 is arranged in the second process station 4 at the conveying system 2 such that the second robot 110 can pick and place items necessary in producing the article onto one of the first to third carriers 70, 80, 90 and/or the load 72.

Fig. 2 shows the robot 110 in more detail in a side view of Fig. 1. The robot 110 comprises a support 111 supporting an arm 112 carrying an item 113 picked by the robot 110. The robot 110 can place the item 113 onto the carrier 90 or the load 72, if the load 72 is present on the carrier 90. The robot 100 is configured in the same way like the robot 110 even if the robot 100 is not shown in detail.

In the present embodiment, the first to third carriers 70, 80, 90 are provided with magnetic elements (not shown) for cooperating with the first to sixth driving devices 10, 20, 30, 40, 50, 60. The magnetic elements can create magnetic force caused by a control performed by the control device 3. Therewith, the first to third carriers 70, 80, 90 can be moved in the conveying system 2 individually or together between and/or to or away from the both process stations 3, 4. According to the invention, the first to third carriers 70, 80, 90 can be moved in the conveying system 2 so that at least one of them has an individual velocity. Alternatively, the first to third carriers 70, 80, 90 can be moved in the conveying system 2 so that each has the same velocity.

The control of the movement of the first to third carriers 70, 80, 90 is performed by the first control unit 6. Herein, the first to third carriers 70, 80, 90 are conveyed and thus moved in a specific conveying direction. This specific conveying direction is in Figs. 1 and 2 the X-direction shown with an arrow X of the coordinate system on the right side in Figs. 1 and 2. Herein, the first to third carriers 70, 80, 90 can be moved back and forth in the X-direction, as it is needed. In case one carrier of the first to third carriers 70, 80, 90 is in reach of one robot of the first and second robots 100, 110, the movement of the carrier is coupled, in particular synchronized, with the movement of the corresponding robot 100, 110 where the carrier is arranged. This is described in more detail in the following.

In Fig. 1, the robot 100 is arranged such that a carrier 70, 80, 90 is arranged above the driving device 20 when the carrier 70, 80, 90 is arranged below the robot 100. In such a case, the carrier 70, 80, 90 is driven by the driving device 20 which is controlled by the first control unit 6, as described above.

In Fig. 1 the carrier 70 is arranged partly over the driving device 20 and partly below the robot 100.

Further in Fig. 1, the robot 110 is arranged such that a carrier 70, 80, 90 is arranged above the driving device 50 when the carrier 70, 80, 90 is arranged below the robot 110. In Fig. 1 the carrier 90 is arranged over the driving device 50 and below the robot 110. In such a case, the carrier 70, 80, 90 is driven by the driving device 50 which is controlled by the first control unit 6, too, as described above.

In contrast thereto, the control of the movement of the first robot 100 is performed by the second control unit 7. And, the control of the movement of the second robot 110 is performed by the third control unit 8. Herein, the first and second robots 100, 110 and/or the arm 112 thereof can be moved back and forth in the Y-direction, as it is needed. The Y-direction is shown with an arrow Y of the coordinate system on the right side in Figs. 1 and 2. Alternatively or additionally, the first and second robots 100, 110 and/or the arm 112 thereof can be moved back and forth in the Z-direction, as it is needed. The Z-direction is shown with an arrow Z of the coordinate system on the right side in Figs. 1 and 2. Alternatively or additionally, the first and second robots 100, 110 and/or the arm 112 thereof can be moved back and forth in the Θ-direction, as it is needed. However, the first and second robots 100, 110 and/or the arm 112 thereof do not need to move in the X-direction, since a movement in the X-direction is performed by the first to third carriers 70, 80, 90 due to a control performed by the first control unit 6. In other words, the conveying system 2 takes over the movement in one direction so that the robots 100, 110 do not have to move in the direction taken over by the conveying system 2. To achieve a movement in all directions needed in the production process performed in the machine 1, the first and second robots 100, 110 take over the other moving directions which are not handled by the conveying system 2.

By controlling the movement of the carriers 70, 80, 90 and thus a load 72 in the X-direction by the first control unit 6 as described above, while the carriers 70, 80, 90 and thus the load 72 is within the reach of one of the robots 100, 110, it becomes possible to move the robot 100, 110 only in the Y-direction and/or the Z- and/or the Θ-directions adapted or coupled to the movement of the carriers 70, 80, 90 and thus the load 72 in the X-direction. In particular, the movement of the carriers 70, 80, 90 and thus the load 72 in the X-direction is performed synchronously with the movement of the specific robot 100, 110 in the Y-direction and/or the Z-direction and/or the Θ-direction.

Thus, it is no longer necessary for the robots 100, 110, to move in the specific conveying direction which is the X-direction in Fig. 1. A coupling or synchroniszation of the conveying system 2 with conventionally controlled peripherals like the robots 100, 110 is possible.

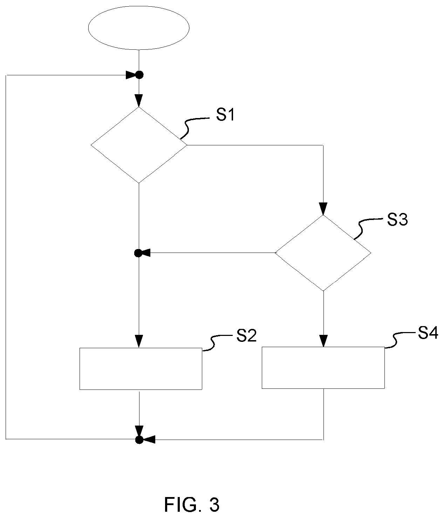

Fig. 3 shows a control method which can be performed by the control device 5 for controlling the conveying system 2 and the robots 100, 110 of the machine 1.

After a start of the control method, in a step S1, it is determined whether one of the carriers 70, 80, 90 is positioned over the driving device 20 or the driving device 50 and is thus in reach of the first or second robots 100, 110. In case no one of the carriers 70, 80, 90 is positioned over the driving device 20 or the driving device 50, the flow goes further to a step S2. Otherwise, the flow goes further to a step S3.

In the step S2, the driving devices 10, 30, 40, 60 over which a carrier of the carriers 70, 80, 90 is positioned are driven as required so that the carriers 70, 80, 90 are moved between or to or away from the first and second process stations 3, 4 and thus the robots 100, 110. Thereafter, the flow goes back to the step S1.

In the step S3, it is checked, whether the process time in the corresponding process station 3, 4 is already over since the carrier of the carriers 70, 80, 90 is positioned over the driving device 20 or the driving device 50. In addition or alternatively, it could be checked, whether all required process steps have been executed at the current process station. Thus, the check could be time-based or based on knowledge about the required steps to be executed at each station or based on both. In case the check is positive, for example the process time is already over, the flow goes further to the step S2. In case the check is negative, for example the process time is not over, the flow goes further to the step S4.

In the step S4, the driving device 20 or the driving device 50, over which a carrier of the carriers 70, 80, 90 is positioned, is driving the carrier by a control of the first control unit 6. The control of the first control unit 6 is adapted or coupled to the movement controlled by the second or third control unit 7, 8. In particular, the control is performed such that the movement of the load 72 in the X-direction is performed synchronously with the movement of the corresponding robot 100, 110 in the Y-direction and/or the Z- and/or the Θ-direction. Thereafter, the flow goes back to the step S1.

Consequently, the control according to the step S4 is performed only during the process time in the corresponding process stations 3, 4.

The control method is finished, when the machine 1 and/or the conveying system 2 and/or the control device 3 and/or the robots 100, 110 are switched off.

The machine 1 according to the first embodiment is particularly advantageous when there are multiple process stations 3, 4, since the cost savings increases with the number of process stations 3, 4.

According to a second embodiment, the conveying system 2 is configured such that the carriers 70, 80, 90 can move not only in the X-direction but also in the Y-direction. That is, the conveying system 2 is configured such that the carriers 70, 80, 90 can move in two directions. In such a case, the robots 100, 110 only need to move in the Z-direction and the Θ-direction.

Such a configuration will lower the costs for the robots 100, 110 but increase the costs for the conveying system 2. Thus, the second embodiment is more advantageous for a machine 1, in which a short conveying system 2 but a lot of robots 100, 110 are used.

All of the previously described implementation forms of the machine 1, the conveying system 2, the process stations 3, 4, the control means 5 and the control method can be used separately or in all possible combinations thereof. In particular, the features of the first and second embodiments can be combined arbitrarily, while the scope of the invention is strictly defined by the appended claims. The following modifications are conceivable.

The elements shown in the drawings are shown schematically and can differ in the actual implementation form from the forms shown in the drawings whilst the above-described functions are ensured.

The driving devices 10, 20, 30, 40, 50, 60 can each be a coil or a motor producing a magnetic field causing the carriers 70, 80, 90 to move according to an cooperation of their magnetic elements with the magnetic field produced by the driving devices 10, 20, 30, 40, 50, 60. The number of the driving devices 10, 20, 30, 40, 50, 60 can be selected as desired. In addition, coils and/or motors can be present in one conveying system 2 or a track thereof.

The driving units 10, 20, 30, 40, 50, 60 can be provided with an integrated magnetic sensor 100, in particular hall sensors, for detecting whether one or more of the carriers 70, 80, 90 is/are arranged at the driving devices 10, 20, 30, 40, 50, 60.

The number of the tracks formed by the driving devices 10, 20, 30, 40, 50, 60 can be selected arbitrarily. Further, a track can also form a loop, in particular in the form of an ellipse.

The number of the process stations 3, 4 can be selected arbitrarily. In addition, the number of robots used in one of the process stations 3, 4 can be selected arbitrarily. The robots can be placed on different sides of the conveying system 2, as well.

The control method can be performed in various other ways insofar the function described above is achieved. For example, the step S3 can be performed together with the step S4. Herein, a timer can be started to trigger the start and end of the control according to the step S4.

The dimensions shown in the drawings are used for illustrating the principle of the invention and are not limiting. The actual dimensions of the machine 1 and the components thereof can be selected as appropriate.

## Claims

1. Machine (1), comprising
a conveying system (2) for conveying carriers (70, 80, 90) by magnetic force in a specific conveying direction, at least one of the carriers (70, 80, 90) being usable for conveying a load (72) to be handled in the machine (1),
at least one process station (3, 4) comprising a robot (100, 110) for handling the load (72) being conveyed by the at least one carrier (70, 80, 90) in a process performed in the machine,
a first control unit (6) configured for controlling the carriers (70, 80, 90) to move by magnetic force in the specific conveying direction, a second control unit (7) configured for controlling the robot (100, 110) to move in a moving direction different from the specific conveying direction to handle the load (72),
wherein the conveying system (2) is arranged to convey the carriers (70, 80, 90) in the specific conveying direction for conveying the load (72) to and/or away from the at least one process station (3, 4) and to convey the carriers (70, 80, 90) in the same specific conveying direction for conveying the load (72) in the at least one process station (3, 4),
wherein the first control unit (6) is further configured to perform a control in which at least one of the carriers (70, 80, 90) has an individual velocity, such that the at least one carrier (70, 80, 90) can be moved back and forth in the specific conveying direction and such that in case the carrier (70, 80, 90) is in reach of the robot (100, 110), the movement of the carrier (70, 80, 90) is coupled, in particular synchronized, with the movement of the robot (100, 110), and
wherein the first and second control units (6, 7) are configured to perform a control in which during performing a process in the at least one process station (3, 4) the movement of the robot (100, 110) is coupled to the movement of the at least one carrier (70, 80, 90) carrying the load (72) such that the specific conveying direction for conveying the load (72) and the moving direction of the robot (100, 110) are superimposed to handle the load (72) in the process performed in the at least one process station (3, 4) to eliminate a need for a movement of the robot (100, 110) in the conveying direction of the conveying system (2).

2. Machine (1) according to claim 1, wherein the control performed by the first control unit for conveying the load (72) in the specific conveying direction and the control performed by the second control unit for moving the robot (100, 110) in the moving direction are synchronized in handling the load (72).

3. Machine (1) according to claim 1 or 2, wherein the first control unit (6, 7) is configured to perform a control in which during performing the process in the process station (3, 4) the carriers (70, 80, 90) are movable only in the specific conveying direction or are movable in two directions positioned vertically to each other and different from a moving direction or moving directions of the robot (100, 110).

4. Machine (1) according to any one of the claims 1 to 3, wherein the process station (3, 4) comprises more than one robot (100, 110).

5. Machine (1) according to any one of the claims 1 to 3, wherein the process station (3, 4) is suitable to be used in a process requiring a positioning accuracy of up to approximately 1 µm for handling the load (72).

6. Machine (1) according to any one of the claims 1 to 4, wherein the process station (3, 4) is a process station for producing a semiconductor element.

7. Machine (1) according to any one of the claims 1 to 6, wherein the conveying system (2) is configured to convey a substrate as the load (72) and the robot (100, 110) is configured to add items (113) to the substrate.

8. Control device (5) for controlling a movement in a process of a machine (1), comprising
a first control unit (6) configured for controlling a carrier (70, 80, 90), which carrier (70, 80, 90) is to be conveyed by magnetic force in a specific conveying direction of a conveying system (2), the carrier (70, 80, 90) being used for conveying a load (72) to be handled in the machine (1) in at least one process station (3, 4), the conveying system (2) being arranged to convey the carriers (70, 80, 90) in the specific conveying direction for conveying the load (72) to and/or away from the at least one process station (3, 4) and to convey the carriers (70, 80, 90) in the same specific conveying direction for conveying the load (72) in the at least one process station (3, 4), and
a second control unit (7) configured for controlling a robot (100, 110) in the at least one process station (3, 4) to move in a moving direction different from the specific conveying direction to handle the load (72) in a process performed in the machine, wherein the first control unit (6) is further configured to perform a control in which at least one of the carriers (70, 80, 90) has an individual velocity, such that the carrier (70, 80, 90) can be moved back and forth in the specific conveying direction and such that in case the carrier (70, 80, 90) is in reach of the robot (100, 110), the movement of the carrier (70, 80, 90) is coupled, in particular synchronized, with the movement of the robot (100, 110), and
wherein the first and second control units (6, 7) are configured to perform a control in which during performing a process in the at least one process station (3, 4) the movement of the robot (100, 110) is coupled to the movement of the carrier (70, 80, 90) carrying the load (72) such that the specific conveying direction for conveying the load (72) and the moving direction of the robot (100, 110) are superimposed in handling the load (72) in the process performed in the at least one process station (3,4) of the machine (1) to eliminate a need for a movement of the robot (100, 110) in the conveying direction of the conveying system (2).

9. Control device (5) according to claim 8, wherein the control performed by the first control unit for conveying the load (72) in the specific conveying direction and the control performed by the second control unit for moving the robot (100, 110) in the moving direction are synchronized in handling the load (72).

10. Control device (5) according to claim 8 or 9, wherein the first control unit (6, 7) is configured to perform a control in which during performing the process in the process station (3, 4) the carriers (70, 80, 90) are movable only in the specific conveying direction or are movable in two directions positioned vertically to each other and different from a moving direction or moving directions of the robot (100, 110).

11. Control device according to any one of the claims 8 to 9, wherein the first control unit (6) is configured to control the carrier (70, 80, 90) such that the load (72) is moved in the specific conveying direction such that the robot (100, 110) does not have to move in the specific conveying direction.

12. Control device (5) according to any one of the claims 8 to 11,
wherein the specific conveying direction is the X-direction,
wherein the moving direction of the robot (100, 110) is at least one direction of the Y-direction and/or the Z-direction and/or the Θ-direction, and
wherein the X-direction, the Y-direction and the Z-direction are different from each other and are arranged vertically to each other.

13. Control method for controlling a movement in a process of a machine (1), comprising the steps of
controlling, by a first control unit (6), carriers (70, 80, 90) to be conveyed by magnetic force in a specific conveying direction of a conveying system (2), the carrier (70, 80, 90) being used for conveying a load (72) to be handled in the machine in at least one process station (3, 4), the conveying system (2) being arranged to convey the carriers (70, 80, 90) in the specific conveying direction for conveying the load (72) to and/or away from the at least one process station (3, 4) and to convey the carriers (70, 80, 90) in the same specific conveying direction for conveying the load (72) in the at least one process station (3, 4), and
controlling, by a second control unit (7), a robot (100, 110) in the at least one process station (3, 4) to move in a moving direction different from the specific conveying direction to handle the load (72) in a process performed in the machine,
wherein the first control unit (6) performs a control in which at least one of the carriers (70, 80, 90) has an individual velocity, such that the carrier (70, 80, 90) can be moved back and forth in the specific conveying direction and such that in case the carrier (70, 80, 90) is in reach of the robot (100, 110), the movement of the carrier (70, 80, 90) is coupled, in particular synchronized, with the movement of the robot (100, 110), and
wherein the first and second control units (6, 7) perform a control in which during performing a process in the process station (3, 4) the movement of the robot (100, 110) is coupled to the movement of the carrier (70, 80, 90) carrying the load (72) such that the specific conveying direction for conveying the load (72) and the moving direction of the robot (100, 110) are superimposed in handling the load (72) in the process performed in the at least one process station (3, 4) of the machine (1) to eliminate a need for a movement of the robot (100, 110) in the conveying direction of the conveying system (2).

14. Control method according to claim 13,
wherein the control performed by the first control unit for conveying the load (72) in the specific conveying direction and the control performed by the second control unit for moving the robot (100, 110) in the moving direction are synchronized in handling the load (72), and/or
wherein during performing the process in the process station (3, 4) the carriers (70, 80, 90) are moved only in the specific conveying direction or are moved in two directions positioned vertically to each other and different from a moving direction or moving directions of the robot (100, 110).

15. Control method according to claim 13 or 14,
wherein the specific conveying direction is the X-direction,
wherein the moving direction of the robot (100, 110) is at least one direction of the Y-direction and/or the Z-direction and/or the Θ-direction, and
wherein the X-direction, the Y-direction and the Z-direction are different from each other and are arranged vertically to each other.

## Patentansprüche

1. Maschine (1), umfassend
ein Fördersystem (2) zum Fördern von Trägern (70, 80, 90) durch Magnetkraft in eine spezifische Förderrichtung, wobei mindestens einer der Träger (70, 80, 90) zum Fördern einer in der Maschine (1) zu handhabenden Last (72) verwendbar ist,
mindestens eine Prozessstation (3, 4), umfassend einen Roboter (100, 110) zum Handhaben der durch den mindestens einen Träger (70, 80, 90) geförderten Last (72) in einem in der Maschine durchgeführten Prozess,
eine erste Steuereinheit (6), die dazu ausgelegt ist, die Träger (70, 80, 90) derart zu steuern, dass sie sich durch Magnetkraft in der spezifischen Förderrichtung bewegen,
eine zweite Steuereinheit (7), die dazu ausgelegt ist, den Roboter (100, 110) derart zu steuern, dass er sich in einer von der spezifischen Förderrichtung unterschiedlichen Bewegungsrichtung bewegt, um die Last (72) zu handhaben,
wobei das Fördersystem (2) dazu angeordnet ist, um die Träger (70, 80, 90) in der spezifischen Förderrichtung zum Fördern der Last (72) zu und/oder weg von der mindestens einen Prozessstation (3, 4) zu fördern, und um die Träger (70, 80, 90) in derselben spezifischen Förderrichtung zum Fördern der Last (72) in der mindestens einen Prozessstation (3, 4) zu fördern,
wobei die erste Steuereinheit (6) ferner dazu ausgelegt ist, eine Steuerung durchzuführen, bei der mindestens einer der Träger (70, 80, 90) eine individuelle Geschwindigkeit aufweist, so dass der mindestens eine Träger (70, 80, 90) in der spezifischen Förderrichtung vor- und zurückbewegt werden kann, und so dass, falls der Träger (70, 80, 90) in Reichweite des Roboters (100, 110) ist, die Bewegung des Trägers (70, 80, 90) mit der Bewegung des Roboters (100, 110) gekoppelt, insbesondere synchronisiert, ist, und
wobei die ersten und zweiten Steuereinheiten (6, 7) dazu ausgelegt sind, eine Steuerung durchzuführen, bei der während eines Durchführens eines Prozesses in der mindestens einen Prozessstation (3, 4) die Bewegung des Roboters (100, 110) mit der Bewegung des mindestens einen die Last (72) tragenden Trägers (70, 80, 90) derart gekoppelt ist, dass die spezifische Förderrichtung zum Fördern der Last (72) und die Bewegungsrichtung des Roboters (100, 110) überlagert sind, um die Last (72) in dem in der mindestens einen Prozessstation (3, 4) durchgeführten Prozess zu handhaben, um ein Erfordernis für eine Bewegung des Roboters (100, 110) in der Förderrichtung des Fördersystems (2) zu eliminieren.

2. Maschine (1) nach Anspruch 1, wobei die durch die erste Steuereinheit durchgeführte Steuerung zum Fördern der Last (72) in der spezifischen Förderrichtung und die durch die zweite Steuereinheit durchgeführte Steuerung zum Bewegen des Roboters (100, 110) in der Bewegungsrichtung bei Handhaben der Last (72) synchronisiert sind.

3. Maschine (1) nach Anspruch 1 oder 2, wobei die erste Steuereinheit (6, 7) dazu ausgelegt ist, eine Steuerung durchzuführen, bei der während eines Durchführens des Prozesses in der Prozessstation (3, 4) die Träger (70, 80, 90) nur in der spezifischen Förderrichtung bewegbar sind oder in zwei Richtungen bewegbar sind, die senkrecht zueinander positioniert und von einer Bewegungsrichtung oder Bewegungsrichtungen des Roboters (100, 110) unterschiedlich sind.

4. Maschine (1) nach einem der Ansprüche 1 bis 3, wobei die Prozessstation (3, 4) mehr als einen Roboter (100, 110) umfasst.

5. Maschine (1) nach einem der Ansprüche 1 bis 3, wobei die Prozessstation (3, 4) dazu geeignet ist, in einem Prozess verwendet zu werden, der eine Positionierungsgenauigkeit von bis zu ungefähr 1 µm zum Handhaben der Last (72) erfordert.

6. Maschine (1) nach einem der Ansprüche 1 bis 4, wobei die Prozessstation (3, 4) eine Prozessstation zum Herstellen eines Halbleiterelements ist.

7. Maschine (1) nach einem der Ansprüche 1 bis 6, wobei das Fördersystem (2) dazu ausgelegt ist, ein Substrat als die Last (72) zu fördern, und der Roboter (100, 110) dazu ausgelegt ist, Objekte (113) zu dem Substrat hinzuzufügen.

8. Steuervorrichtung (5) zum Steuern einer Bewegung in einem Prozess einer Maschine (1), umfassend
eine erste Steuereinheit (6), die dazu ausgelegt ist, einen Träger (70, 80, 90) zu steuern, wobei der Träger (70, 80, 90) durch Magnetkraft in einer spezifischen Förderrichtung eines Fördersystems (2) gefördert werden soll, wobei der Träger (70, 80, 90) zum Fördern einer in der Maschine (1) in mindestens einer Prozessstation (3, 4) zu handhabenden Last (72) verwendet wird, wobei das Fördersystem (2) dazu angeordnet ist, die Träger (70, 80, 90) in der spezifischen Förderrichtung zum Fördern der Last (72) zu und/oder weg von der mindestens einen Prozessstation (3, 4) zu fördern, und um die Träger (70, 80, 90) in derselben spezifischen Förderrichtung zum Fördern der Last (72) in der mindestens einen Prozessstation (3, 4) zu fördern, und
eine zweite Steuereinheit (7), die dazu ausgelegt ist, einen Roboter (100, 110) in der mindestens einen Prozessstation (3, 4) derart zu steuern, dass er sich in einer von der spezifischen Förderrichtung unterschiedlichen Bewegungsrichtung bewegt, um die Last (72) in einem in der Maschine durchgeführten Prozess zu handhaben, wobei die erste Steuereinheit (6) ferner dazu ausgelegt ist, eine Steuerung durchzuführen, bei der mindestens einer der Träger (70, 80, 90) eine individuelle Geschwindigkeit aufweist, so dass der Träger (70, 80, 90) in der spezifischen Förderrichtung vor- und zurückbewegt werden kann, und so dass, falls der Träger (70, 80, 90) in Reichweite des Roboters (100, 110) ist, die Bewegung des Trägers (70, 80, 90) mit der Bewegung des Roboters (100, 110) gekoppelt, insbesondere synchronisiert, ist, und
wobei die ersten und zweiten Steuereinheiten (6, 7) dazu ausgelegt sind, eine Steuerung durchzuführen, bei der während eines Durchführens eines Prozesses in der mindestens einen Prozessstation (3, 4) die Bewegung des Roboters (100, 110) mit der Bewegung des die Last (72) tragenden Trägers (70, 80, 90) derart gekoppelt ist, dass die spezifische Förderrichtung zum Fördern der Last (72) und die Bewegungsrichtung des Roboters (100, 110) bei Handhaben der Last (72) in dem in der mindestens einen Prozessstation (3, 4) der Maschine (1) durchgeführten Prozess überlagert sind, um ein Erfordernis für eine Bewegung des Roboters (100, 110) in der Förderrichtung des Fördersystems (2) zu eliminieren.

9. Steuervorrichtung (5) nach Anspruch 8, wobei die durch die erste Steuereinheit durchgeführte Steuerung zum Fördern der Last (72) in der spezifischen Förderrichtung und die durch die zweite Steuereinheit durchgeführte Steuerung zum Bewegen des Roboters (100, 110) in der Bewegungsrichtung bei Handhaben der Last (72) synchronisiert sind.

10. Steuervorrichtung (5) nach Anspruch 8 oder 9, wobei die erste Steuereinheit (6, 7) dazu ausgelegt ist, eine Steuerung durchzuführen, bei der während eines Durchführens des Prozesses in der Prozessstation (3, 4) die Träger (70, 80, 90) nur in der spezifischen Förderrichtung bewegbar sind oder in zwei Richtungen bewegbar sind, die senkrecht zueinander positioniert und von einer Bewegungsrichtung oder Bewegungsrichtungen des Roboters (100, 110) unterschiedlich sind.

11. Steuervorrichtung nach einem der Ansprüche 8 bis 9, wobei die erste Steuereinheit (6) dazu ausgelegt ist, den Träger (70, 80, 90) derart zu steuern, dass die Last (72) in der spezifischen Förderrichtung derart bewegt wird, dass sich der Roboter (100, 110) nicht in der spezifischen Förderrichtung bewegen muss.

12. Steuervorrichtung (5) nach einem der Ansprüche 8 bis 11,
wobei die spezifische Förderrichtung die X-Richtung ist,
wobei die Bewegungsrichtung des Roboters (100, 110) mindestens eine Richtung der Y-Richtung und/oder der Z-Richtung und/oder der θ-Richtung ist, und
wobei die X-Richtung, die Y-Richtung und die Z-Richtung voneinander unterschiedlich sind und senkrecht zueinander angeordnet sind.

13. Steuerverfahren zum Steuern einer Bewegung in einem Prozess einer Maschine (1), umfassend die folgenden Schritte
Steuern, durch eine erste Steuereinheit (6), von Trägern (70, 80, 90), die durch Magnetkraft in einer spezifischen Förderrichtung eines Fördersystems (2) gefördert werden sollen, wobei der Träger (70, 80, 90) zum Fördern einer in der Maschine in mindestens einer Prozessstation (3, 4) zu handhabenden Last (72) verwendet wird, wobei das Fördersystem (2) dazu angeordnet ist, um die Träger (70, 80, 90) in der spezifischen Förderrichtung zum Fördern der Last (72) zu und/oder weg von der mindestens einen Prozessstation (3, 4) zu fördern, und um die Träger (70, 80, 90) in derselben spezifischen Förderrichtung zum Fördern der Last (72) in der mindestens einen Prozessstation (3, 4) zu fördern, und
Steuern, durch eine zweite Steuereinheit (7), eines Roboters (100, 110) in der mindestens einen Prozessstation (3, 4) derart, dass er sich in einer von der spezifischen Förderrichtung unterschiedlichen Bewegungsrichtung bewegt, um die Last (72) in einem in der Maschine durchgeführten Prozess zu handhaben,
wobei die erste Steuereinheit (6) eine Steuerung durchführt, bei der mindestens einer der Träger (70, 80, 90) eine individuelle Geschwindigkeit aufweist, so dass der Träger (70, 80, 90) in der spezifischen Förderrichtung vor- und zurückbewegt werden kann, und so dass, falls der Träger (70, 80, 90) in Reichweite des Roboters (100, 110) ist, die Bewegung des Trägers (70, 80, 90) mit der Bewegung des Roboters (100, 110) gekoppelt, insbesondere synchronisiert, wird, und
wobei die ersten und zweiten Steuereinheiten (6, 7) eine Steuerung durchführen, bei der während eines Durchführens eines Prozesses in der mindestens einen Prozessstation (3, 4) die Bewegung des Roboters (100, 110) mit der Bewegung des die Last (72) tragenden Trägers (70, 80, 90) derart gekoppelt wird, dass die spezifische Förderrichtung zum Fördern der Last (72) und die Bewegungsrichtung des Roboters (100, 110) bei Handhaben der Last (72) in dem in der mindestens einen Prozessstation (3, 4) der Maschine (1) durchgeführten Prozess überlagert werden, um ein Erfordernis für eine Bewegung des Roboters (100, 110) in der Förderrichtung des Fördersystems (2) zu eliminieren.

14. Steuerverfahren nach Anspruch 13,
wobei die durch die erste Steuereinheit durchgeführte Steuerung zum Fördern der Last (72) in der spezifischen Förderrichtung und die durch die zweite Steuereinheit durchgeführte Steuerung zum Bewegen des Roboters (100, 110) in der Bewegungsrichtung bei Handhaben der Last (72) synchronisiert werden, und/oder
wobei während eines Durchführens des Prozesses in der Prozessstation (3, 4) die Träger (70, 80, 90) nur in der spezifischen Förderrichtung bewegt werden oder in zwei Richtungen bewegt werden, die senkrecht zueinander positioniert und von einer Bewegungsrichtung oder Bewegungsrichtungen des Roboters (100, 110) unterschiedlich sind.

15. Steuerverfahren nach Anspruch 13 oder 14,
wobei die spezifische Förderrichtung die X-Richtung ist,
wobei die Bewegungsrichtung des Roboters (100, 110) mindestens eine Richtung der Y-Richtung und/oder der Z-Richtung und/oder der θ-Richtung ist, und
wobei die X-Richtung, die Y-Richtung und die Z-Richtung voneinander unterschiedlich sind und senkrecht zueinander angeordnet sind.

## Revendications

1. Machine (1), comprenant
un système de convoyage (2), pour convoyer des transporteurs (70, 80, 90) par force magnétique dans une direction de convoyage spécifique, au moins un des transporteurs (70, 80, 90) étant utilisable pour convoyer une charge (72) destinée à être manipulée dans la machine (1),
au moins un poste de traitement (3, 4), comprenant un robot (100, 110) pour manipuler la charge (72), en train d'être convoyée par l'au moins un transporteur (70, 80, 90), dans un traitement réalisé dans la machine,
une première unité de commande (6), configurée pour commander les transporteurs (70, 80, 90) pour se mouvoir par force magnétique dans la direction de convoyage spécifique,
une seconde unité de commande (7), configurée pour commander le robot (100, 110) pour se mouvoir dans une direction de mouvement différente de la direction de convoyage spécifique pour manipuler la charge (72),
dans laquelle le système de convoyage (2) est agencé pour convoyer les transporteurs (70, 80, 90) dans la direction de convoyage spécifique pour convoyer la charge (72) vers, et/ou à l'opposé de, l'au moins un poste de traitement (3, 4) et pour convoyer les transporteurs (70, 80, 90) dans la même direction de convoyage spécifique pour convoyer la charge (72) dans l'au moins un poste de traitement (3, 4),
dans laquelle la première unité de commande (6) est en outre configurée pour réaliser une commande dans laquelle au moins un des transporteurs (70, 80, 90) a une vitesse individuelle, de telle sorte que l'au moins un transporteur (70, 80, 90) puisse être mû en va-et-vient dans la direction de convoyage spécifique et de telle sorte que, au cas où le transporteur (70, 80, 90) est au sein de la portée du robot (100, 110), le mouvement du transporteur (70, 80, 90) soit couplé, en particulier synchronisé, avec le mouvement du robot (100, 110), et
dans laquelle les première et seconde unités de commande (6, 7) sont configurées pour réaliser une commande dans laquelle, durant la réalisation d'un traitement dans l'au moins un poste de traitement (3, 4), le mouvement du robot (100, 110) est couplé au mouvement de l'au moins un transporteur (70, 80, 90) transportant la charge (72) de telle sorte que la direction de convoyage spécifique pour convoyer la charge (72) et la direction de mouvement du robot (100, 110) soient superposées pour manipuler la charge (72) dans le traitement réalisé dans l'au moins un poste de traitement (3, 4) pour éliminer un besoin d'un mouvement du robot (100, 110) dans la direction de convoyage du système de convoyage (2).

2. Machine (1) selon la revendication 1, dans laquelle la commande réalisée par la première unité de commande pour convoyer la charge (72) dans la direction de convoyage spécifique et la commande réalisée par la seconde unité de commande pour mouvoir le robot (100, 110) dans la direction de mouvement sont synchronisées dans la manipulation de la charge (72).

3. Machine (1) selon la revendication 1 ou 2, dans laquelle la première unité de commande (6, 7) est configurée pour réaliser une commande dans laquelle, durant la réalisation du traitement dans le poste de traitement (3, 4), les transporteurs (70, 80, 90) sont mobiles seulement dans la direction de convoyage spécifique ou sont mobiles dans deux directions positionnées verticalement l'une à l'autre et différentes d'une direction de mouvement ou de directions de mouvement du robot (100, 110).

4. Machine (1) selon l'une quelconque des revendications 1 à 3, dans laquelle le poste de traitement (3, 4) comprend plus d'un robot (100, 110).

5. Machine (1) selon l'une quelconque des revendications 1 à 3, dans laquelle le poste de traitement (3, 4) est approprié pour être utilisé dans un traitement exigeant une précision de positionnement d'au maximum approximativement 1 µm pour manipuler la charge (72).

6. Machine (1) selon l'une quelconque des revendications 1 à 4, dans laquelle le poste de traitement (3, 4) est un poste de traitement pour produire un élément semi-conducteur.

7. Machine (1) selon l'une quelconque des revendications 1 à 6, dans laquelle le système de convoyage (2) est configuré pour convoyer un substrat en tant que charge (72) et le robot (100, 110) est configuré pour ajouter des articles (113) sur le substrat.

8. Dispositif de commande (5) pour commander un mouvement dans un traitement d'une machine (1), comprenant
une première unité de commande (6) configurée pour commander un transporteur (70, 80, 90), lequel transporteur (70, 80, 90) est destiné à être convoyé par force magnétique dans une direction de convoyage spécifique d'un système de convoyage (2), le transporteur (70, 80, 90) étant utilisé pour convoyer une charge (72), destinée à être manipulée dans la machine (1), dans au moins un poste de traitement (3, 4), le système de convoyage (2) étant agencé pour convoyer les transporteurs (70, 80, 90) dans la direction de convoyage spécifique pour convoyer la charge (72) vers, et/ou à l'opposé de, l'au moins un poste de traitement (3, 4) et pour convoyer les transporteurs (70, 80, 90) dans la même direction de convoyage spécifique pour convoyer la charge (72) dans l'au moins un poste de traitement (3, 4), et
une seconde unité de commande (7) configurée pour commander un robot (100, 110) dans l'au moins un poste de traitement (3, 4) pour se mouvoir dans une direction de mouvement différente de la direction de convoyage spécifique pour manipuler la charge (72) dans un traitement réalisé dans la machine, dans lequel la première unité de commande (6) est en outre configurée pour réaliser une commande dans laquelle au moins un des transporteurs (70, 80, 90) a une vitesse individuelle, de telle sorte que le transporteur (70, 80, 90) puisse être mû en va-et-vient dans la direction de convoyage spécifique et de telle sorte que, au cas où le transporteur (70, 80, 90) est au sein de la portée du robot (100, 110), le mouvement du transporteur (70, 80, 90) soit couplé, en particulier synchronisé, avec le mouvement du robot (100, 110), et
dans lequel les première et seconde unités de commande (6, 7) sont configurées pour réaliser une commande dans laquelle, durant la réalisation d'un traitement dans l'au moins un poste de traitement (3, 4), le mouvement du robot (100, 110) est couplé au mouvement du transporteur (70, 80, 90) transportant la charge (72) de telle sorte que la direction de convoyage spécifique pour convoyer la charge (72) et la direction de mouvement du robot (100, 110) soient superposées dans la manipulation de la charge (72) dans le traitement réalisé dans l'au moins un poste de traitement (3, 4) de la machine (1) pour éliminer un besoin d'un mouvement du robot (100, 110) dans la direction de convoyage du système de convoyage (2).

9. Dispositif de commande (5) selon la revendication 8, dans lequel la commande réalisée par la première unité de commande pour convoyer la charge (72) dans la direction de convoyage spécifique et la commande réalisée par la seconde unité de commande pour mouvoir le robot (100, 110) dans la direction de mouvement sont synchronisées dans la manipulation de la charge (72).

10. Dispositif de commande (5) selon la revendication 8 ou 9, dans lequel la première unité de commande (6, 7) est configurée pour réaliser une commande dans laquelle, durant la réalisation du traitement dans le poste de traitement (3, 4), les transporteurs (70, 80, 90) sont mobiles seulement dans la direction de convoyage spécifique ou sont mobiles dans deux directions positionnées verticalement l'une à l'autre et différentes d'une direction de mouvement ou de directions de mouvement du robot (100, 110).

11. Dispositif de commande selon l'une quelconque des revendications 8 à 9, dans lequel la première unité de commande (6) est configurée pour commander le transporteur (70, 80, 90) de telle sorte que la charge (72) soit mue dans la direction de convoyage spécifique de telle sorte que le robot (100, 110) n'ait pas besoin de se mouvoir dans la direction de convoyage spécifique.

12. Dispositif de commande (5) selon l'une quelconque des revendications 8 à 11,
dans lequel la direction de convoyage spécifique est la direction X,
dans lequel la direction de mouvement du robot (100, 110) est au moins une direction de la direction Y et/ou de la direction Z et/ou de la direction Θ, et
dans lequel la direction X, la direction Y et la direction Z sont différentes les unes des autres et sont agencées verticalement les unes aux autres.

13. Procédé de commande pour commander un mouvement dans un traitement d'une machine (1), comprenant les étapes de
la commande, par une première unité de commande (6), de transporteurs (70, 80, 90) destinés à être convoyés par force magnétique dans une direction de convoyage spécifique d'un système de convoyage (2), le transporteur (70, 80, 90) étant utilisé pour convoyer une charge (72), destinée à être manipulée dans la machine, dans au moins un poste de traitement (3, 4), le système de convoyage (2) étant agencé pour convoyer les transporteurs (70, 80, 90) dans la direction de convoyage spécifique pour convoyer la charge (72) vers, et/ou à l'opposé de, l'au moins un poste de traitement (3, 4) et pour convoyer les transporteurs (70, 80, 90) dans la même direction de convoyage spécifique pour convoyer la charge (72) dans l'au moins un poste de traitement (3, 4), et
la commande, par une seconde unité de commande (7), d'un robot (100, 110) dans l'au moins un poste de traitement (3, 4) pour se mouvoir dans une direction de mouvement différente de la direction de convoyage spécifique pour manipuler la charge (72) dans un traitement réalisé dans la machine,
dans lequel la première unité de commande (6) réalise une commande dans laquelle au moins un des transporteurs (70, 80, 90) a une vitesse individuelle, de telle sorte que le transporteur (70, 80, 90) puisse être mû en va-et-vient dans la direction de convoyage spécifique et de telle sorte que, au cas où le transporteur (70, 80, 90) est au sein de la portée du robot (100, 110), le mouvement du transporteur (70, 80, 90) soit couplé, en particulier synchronisé, avec le mouvement du robot (100, 110), et
dans lequel les première et seconde unités de commande (6, 7) réalisent une commande dans laquelle, durant la réalisation d'un traitement dans le poste de traitement (3, 4), le mouvement du robot (100, 110) est couplé au mouvement du transporteur (70, 80, 90) transportant la charge (72) de telle sorte que la direction de convoyage spécifique pour convoyer la charge (72) et la direction de mouvement du robot (100, 110) soient superposées dans la manipulation de la charge (72) dans le traitement réalisé dans l'au moins un poste de traitement (3, 4) de la machine (1) pour éliminer un besoin d'un mouvement du robot (100, 110) dans la direction de convoyage du système de convoyage (2).

14. Procédé de commande selon la revendication 13, dans lequel la commande réalisée par la première unité de commande pour convoyer la charge (72) dans la direction de convoyage spécifique et la commande réalisée par la seconde unité de commande pour mouvoir le robot (100, 110) dans la direction de mouvement sont synchronisées dans la manipulation de la charge (72), et/ou
dans lequel, durant la réalisation du traitement dans le poste de traitement (3, 4), les transporteurs (70, 80, 90) sont mus seulement dans la direction de convoyage spécifique ou sont mus dans deux directions positionnées verticalement l'une à l'autre et différentes d'une direction de mouvement ou de directions de mouvement du robot (100, 110).

15. Procédé de commande selon la revendication 13 ou 14,
dans lequel la direction de convoyage spécifique est la direction X,
dans lequel la direction de mouvement du robot (100, 110) est au moins une direction de la direction Y et/ou de la direction Z et/ou de la direction Θ, et
dans lequel la direction X, la direction Y et la direction Z sont différentes les unes des autres et sont agencées verticalement les unes aux autres.
